(19) Europäisches Patentamt

European Patent Office

Office européen des brevets

(11) EP 0 493 015 B1

(12) EUROPEAN PATENT SPECIFICATION

(45) Date of publication and mention
of the grant of the patent:
13.03.1996 Bulletin 1996/11

(51) Int Cl.⁶: **H01L 25/075**, H01L 27/15,
G06K 15/12

(21) Application number: 91311863.4

(22) Date of filing: 20.12.1991

(54) **LED array type light source**

Lichtquelle von LED-Matrix-Typ

Source de lumière à matrice de diodes électroluminescentes

(84) Designated Contracting States:
DE FR GB

(30) Priority: 26.12.1990 JP 406620/90

(43) Date of publication of application:
01.07.1992 Bulletin 1992/27

(73) Proprietor: ROHM CO., LTD.
Kyoto-shi Kyoto 615 (JP)

(72) Inventors:
• Sawase, Kensuke
Ukyo-ku, Kyoto-shi, Kyoto (JP)
• Ogata, Hiromi
Ukyo-ku, Kyoto-shi, Kyoto (JP)

(74) Representative:
Cross, Rupert Edward Blount et al
BOULT, WADE & TENNANT
27 Furnival Street
London EC4A 1PQ (GB)

(56) References cited:
• PATENT ABSTRACTS OF JAPAN vol. 10, no.
209 (E-421)(2265) 22 July 1986 & JP-A-61 48 982
• PATENT ABSTRACTS OF JAPAN vol. 13, no. 23
(E-705) 19 January 1989 & JP-A-63 226 079
• PATENT ABSTRACTS OF JAPAN vol. 12, no. 61
(M-671) 24 February 1988 & JP-A-62 208 965
• IBM TECHNICAL DISCLOSURE BULLETIN, vol.
29, no. 2, 786, New York, US, pp. 859-861
'WAFER LEVEL HYBRIDIZATION OF
INFRARED DIODES FOR DIFFUSE DATA
TRANSMISSION'

## Description

The present invention relates to an LED array type light source particularly suitable for use in image sensors and the like.

In conventional image sensors for reading original documents, such as facsimile machines and the like, it is normal to utilize a light source comprising a plurality of LED's (light emitting diodes). Usually, the plurality of LED's are arranged into a linear light source which comprises a plurality of LED chip trains juxtaposed, each of the LED chip trains including a plurality of LED chips connected in series with one another. However, the optical output of each of the LED chips may be different from those of the other LED chips due to irregular epitaxial growth or the like. It is therefore important how the optical outputs of the LED chip trains are equalized.

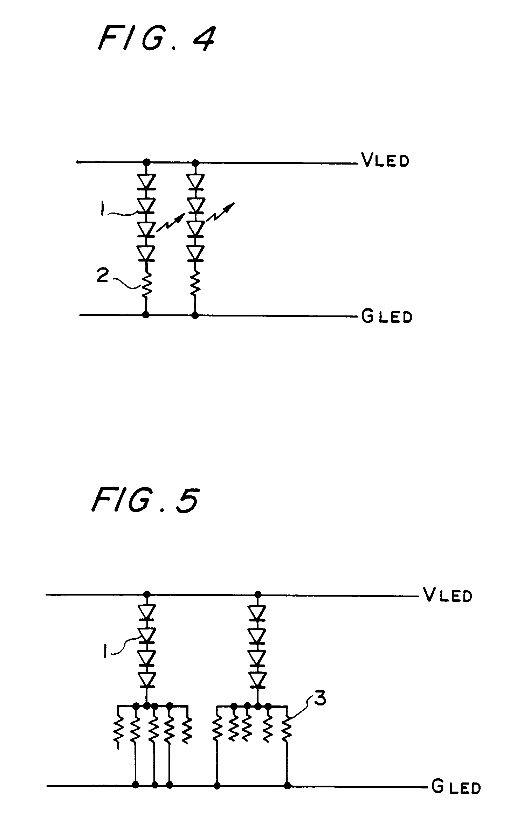

A proposal has been made that a plurality of LED chips 1 connected in series with one another are connected in series with a current regulating resistor 2 as shown in Fig. 4. Such a proposal is intended to provide an equal amount of light from each LED strip by driving them with a constant voltage.

Usually, the selection of the current regulating resistor 2 is made through the following process. A wiring pattern is first formed on a dielectric substrate. LED chips 1 are then die bonded on the substrate. The LED chips 1 are wire bonded to the wiring pattern and also connected in series with one another. Thereafter, a probe is applied to the LED chips 1 so that they are energized to emit light. A resistance for optimizing the amount of light in the LED chips 1 is determined. A chip resistor R having a resistance nearest to the optimum resistance is then selected and mounted on the substrate so that the plurality of LED chips 1 are connected in series with the current regulating resistor 2. Since the resistances of the current regulating resistor 2 are limited, however, it is difficult to accurately regulate the amount of light emitted by the LED chips 1.

JP-A-62 208 965 discloses several current limit resistors serially connected to sub-arrays formed by single LED's connected in parallel.

In order to overcome such a problem, another proposal has been made that the current regulating resistor 2 is replaced by a train of silicon chip resistors 3 connected in series with the plurality of LED chips 1, as shown in Fig. 5. One or more silicon chip resistors 3 are selected from the train so that a resistance nearest to the optimum resistance will be provided. Only the selected silicon chip resistors are bonded to the substrate. See Japanese Utility Model Application No. Hei 1-87590 which has been filed by the applicant.

When the train of silicon chip resistors 3 are connected to the substrate in such a manner, the amount of light in the LED chips 1 can be regulated extremely accurately. However, such an arrangement increases the time required to regulate the amount of light since it requires various processes, namely light measuring, resistor selecting and bonding.

It is therefore an object of the embodiment defined in the claim of the present invention to provide an LED array type light source which can finely regulate the amount of light emitted through a simplified process.

The present invention provides an LED array type light source comprising a substrate, a group of LED chips comprising a plurality of juxtaposed LED chip trains, each of said LED chip trains including a plurality of serially connected LED chips, a plurality of first regulating resistors, each of said first regulating resistors being connected in series with one of said LED chip trains to independently regulate the amount of light in that LED chip train, and a second regulating resistor serially connected in common to said first regulating resistors so that the total amount of light in said group of LED chips can be regulated.

Since the LED array type light source of the present invention includes the first and second regulating resistor means, a desired amount of light through the entire light source system can be simply and readily attained by first equalizing the amount of light in each LED chip train to those of the other LED chip trains and regulating the total amount of light through the light source with the second regulating resistor.

An example of the present invention will now be described with reference to the accompanying drawings in which:

Fig. 1 is a circuit diagram of one embodiment of an LED array type light source constructed in accordance with the present invention.

Fig. 2 is a flow chart illustrating a process of producing the LED array type light source shown in Fig. 1.

Fig. 3 is a flow chart illustrating a process of calculating a common resistor in the LED array type light source shown in Fig. 1.

Fig. 4 is a circuit diagram of an LED array type light source constructed in accordance with the prior art.

Fig. 5 is a circuit diagram of another LED array type light source constructed in accordance with the prior art.

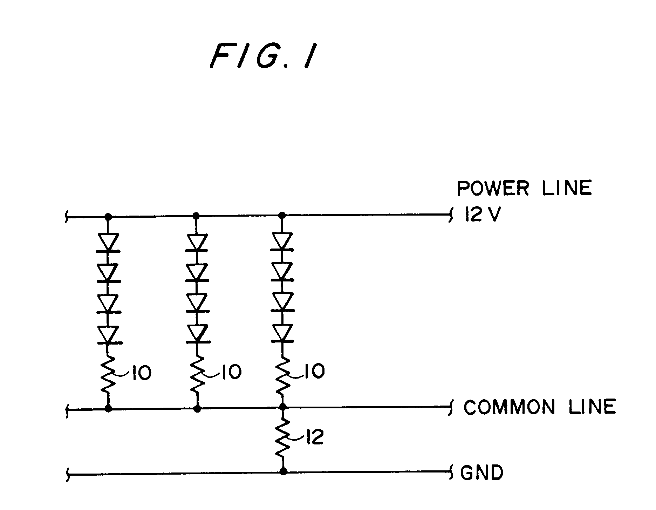

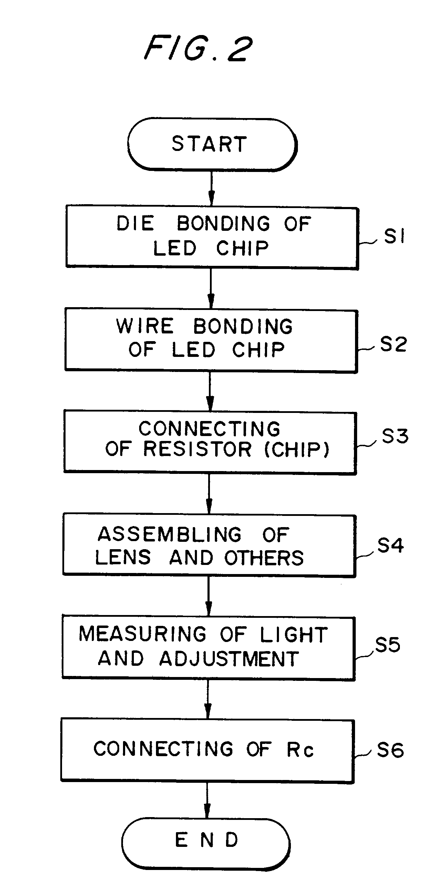

An LED array type light source shown in Fig. 1 may be produced by following a procedure shown in the flow chart of Fig. 2. A plurality of LED chips formed from the same wafer are first die bonded onto a substrate (S1). Each of the LED chips is then wire bonded to a wiring pattern formed on the substrate and connected in series with the other LED chips (S2). Fig. 1 shows three LED chip trains each comprising four LED chips connected in series with one another.

A first regulating resistor 10 having a given fixed resistance is connected in series with each of the three LED chip trains to form an LED array. Each of the LED arrays is connected, at one end, with a power line, the other end of that LED array being connected with a common line (S3).

After the LED arrays are covered and protected by any suitable plastic material, necessary parts such as plastic lens and others are mounted on the circuit substrate (S4).

Since the first regulating resistors 10 are connected in series or directly with the respective LED chip trains so that each of the LED chip trains will receive substantially the same current, there will be very little difference in the amount of light emitted for the same current when the LED chips are formed from the same wafer. As a result, there is substantially no difference in the amount of light between the LED chip trains.

After the first regulating resistors 10 are respectively connected in series with the LED chip trains to equalize the amount of light through the LED chip trains, a common resistor 12 is connected in series with the first regulating resistors 10 between the common line and GND to make the amount of light through the entire light source system a desired level. The resistance of such a common resistor 12 will be calculated through the following procedure (S5 and S6 in Fig. 2).

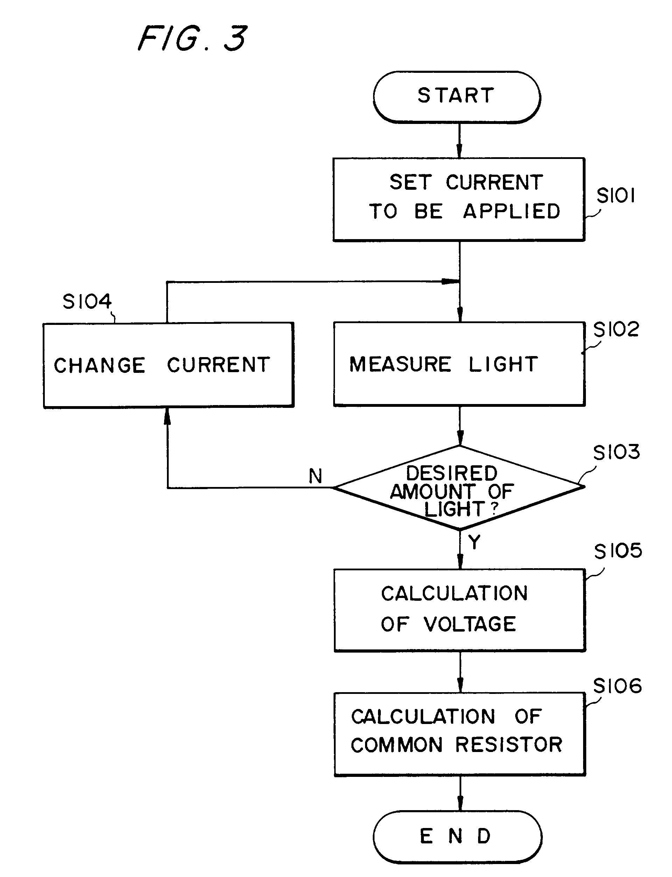

As shown in Fig. 3, a current to be applied to the respective LED chip trains is first set (S101). Light emitted through the plastic lens is then measured (S102). At the next step (S103), it is judged whether or not the measured light is at a desired level. If not, the current level set at the step S101 is changed to another level (S104). The measurement of light is again carried out.

If the desired level of light is attained by repeating the above steps, a voltage between the power line and the common line is then calculated (S105). If it is assumed at this time that a voltage between the power line and the common line is V1 and the supply voltage is V (which is usually equal to 12 volts in image sensor light sources such as facsimile machines and the like), a resistance R to be used in the common resistor 12 can be calculated (at S106) from an equation:

$$R = (V - V1)/I$$

where I is an applied current set at the step S101 or S104.

The common resistor 12 having such a resistance R will be connected between the common line and the GND (S6).

When only one type of first regulating resistors for equalizing any difference in the amount of light through the group of LED chips are connected with the respective LED chip trains or no resistor is connected with the LED chip trains and if a common resistor for regulating the amount of light through the entire light source is connected between the common line and the GND, a desired amount of light can be easily provided. This in turn provides an LED array type light source of high quality which can be produced more simply and inexpensively.

## Claims

1. An LED array type light source comprising:

(a) a substrate;
(b) a group of LED chips comprising a plurality of LED chip trains, each of said LED chip trains including a plurality of serially connected LED chips;
(c) a plurality of first regulating resistors (10), each of said first regulating resistors being connected in series to the respective one of said LED chip trains ; and
(d) each of said LED trains is connected, at one end, with a common power line, the other end of each of said LED trains; being connected with a common line;
characterized in that
(e) a second regulating resistor (12) serially connected in common to said first regulating resistors.

## Patentansprüche

1. LED-Matrix-Lichtquelle umfassend:

(a)   ein Substrat;
(b)   eine Gruppe von LED-Chips umfassend eine Vielzahl von LED-Chipfolgen, die jeweils eine Vielzahl von in Serie geschalteten LED-Chips enthalten;
(c)   eine Vielzahl von ersten Regelwiderständen (10), die jeweils in Serie zu einer jeweiligen LED-Chipfolge geschaltet sind; und
(d)   wobei jede der LED-Folgen an einem Ende mit einer gemeinsamen Spannungsversorgungsleitung und das andere Ende jeder der LED-Folgen mit einer gemeinsamen Leitung verbunden ist;
**dadurch gekennzeichnet,** daß
(e)   ein zweiter Regelwiderstand (12) gemeinsam in Serie zu den ersten Regelwiderständen geschaltet ist.

## Revendications

1. Source de lumière du type à groupement de LED (diodes émettrices de lumière), comprenant :

(a) un substrat ;
(b) un groupe de puces de LED comprenant plusieurs trains de puces de LED, chacun desdits trains de puces de LED comportant plusieurs puces de LED connectées en série :
(c) plusieurs premières résistances de régulation (10), chacune desdites premières résistances de régulation étant connectée en série à l'un respectif desdits trains de puces de LED ; et
(d) chacun desdits trains de LED étant connecté, à une extrémité, à une ligne d'alimentation commune, l'autre extrémité de chacun desdits trains de LED étant connectée à une ligne commune ;
caractérisé en ce que :
(e) une seconde résistance de régulation (12) est connectée en série, en commun, auxdites premières résistances de régulation.

# FIG. 1

POWER LINE
12 V

COMMON LINE

GND

## FIG. 2

```
          ┌──────────────┐
          │    START     │
          └──────┬───────┘
                 │
                 ▼
     ┌────────────────────────┐
     │   DIE  BONDING  OF     │  S1
     │      LED  CHIP         │
     └───────────┬────────────┘
                 │
                 ▼
     ┌────────────────────────┐
     │    WIRE  BONDING       │  S2
     │     OF LED  CHIP       │
     └───────────┬────────────┘
                 │
                 ▼
     ┌────────────────────────┐
     │     CONNECTING         │  S3
     │  OF RESISTOR (CHIP)    │
     └───────────┬────────────┘
                 │
                 ▼
     ┌────────────────────────┐
     │    ASSEMBLING  OF      │  S4
     │   LENS  AND  OTHERS    │
     └───────────┬────────────┘
                 │
                 ▼
     ┌────────────────────────┐
     │  MEASURING  OF LIGHT   │  S5
     │    AND  ADJUSTMENT     │
     └───────────┬────────────┘
                 │
                 ▼
     ┌────────────────────────┐
     │  CONNECTING  OF  Rc    │  S6
     └───────────┬────────────┘
                 │
                 ▼
          ┌──────────────┐
          │    E N D     │
          └──────────────┘
```

# FIG. 3

```
            START
              │
              ▼
       ┌──────────────┐
       │ SET CURRENT  │── S101
       │ TO BE APPLIED│
       └──────────────┘
              │
   ┌──────────┼──────────────┐
   │          ▼              │
┌──────────┐  ┌──────────────┐
│ CHANGE   │  │ MEASURE LIGHT│── S102
│ CURRENT  │  └──────────────┘
└──────────┘         │
 S104                ▼
   │           ╱ DESIRED ╲
   │ N        ╱  AMOUNT OF ╲── S103
   └─────────╲   LIGHT ?   ╱
              ╲           ╱
                   │ Y
                   ▼
           ┌──────────────┐
           │ CALCULATION  │── S105
           │ OF VOLTAGE   │
           └──────────────┘
                   │
                   ▼
           ┌──────────────┐
           │ CALCULATION OF│── S106
           │COMMON RESISTOR│
           └──────────────┘
                   │
                   ▼
               ( END )
```

# FIG. 4

# FIG. 5